Europäisches Patentamt

European Patent Office

Office européen des brevets

(19)

(11) Veröffentlichungsnummer: **0 179 190**
**B1**

(12) # EUROPÄISCHE PATENTSCHRIFT

(45) Veröffentlichungstag der Patentschrift:
**23.08.89**

(51) Int. Cl.⁴: **H 03 F 7/04**, H 01 P 1/00

(21) Anmeldenummer: **85105313.2**

(22) Anmeldetag: **02.05.85**

---

(54) Gleichspannungs- und Hochfrequenzsignalzuführung für eine Diode.

---

(30) Priorität: **24.08.84 DE 3431160**

(43) Veröffentlichungstag der Anmeldung:
**30.04.86 Patentblatt 86/18**

(45) Bekanntmachung des Hinweises auf die Patenterteilung:
**23.08.89 Patentblatt 89/34**

(84) Benannte Vertragsstaaten:
**AT CH DE LI NL**

(56) Entgegenhaltungen:
**DE-A-3 138 173**
**DE-B-1 591 569**
**DE-B-1 766 787**
**DE-B-1 940 902**
**US-A-3 718 866**

**PATENT ABSTRACTS OF JAPAN, Band 6, Nr. 151 (E-124) 1029 , 11. August 1982 & JP-A-57 75002**

(73) Patentinhaber: **ANT Nachrichtentechnik GmbH, Gerberstrasse 33, D-7150 Backnang (DE)**

(72) Erfinder: **Junger, Klaus, Ing. grad., Gartenstrasse 8/1, D-7151 Allmersbach im Tal (DE)**

(74) Vertreter: **Wiechmann, Manfred, Dipl.- Ing., ANT Nachrichtentechnik GmbH Gerberstrasse 33 Postfach 11 20, D-7150 Backnang (DE)**

## Beschreibung

Die vorliegende Erfindung betrifft eine Vorrichtung zum Zuführen einer Gleichspannung und mindestens eines Hochfrequenzsignals an eine in einem Hohlleiter angeordnete Diode, welche mit dem Innenleiter einer die Gleichspannung zuführenden Koaxialleitung kontaktiert ist.

Eine derartige Vorrichtung ist aus der DE-3 138 173 A1 bekannt. Bei dem dieser Schrift zugrundeliegenden parametrischen Verstärker wird über die Koaxialleitung neben der Gleichspannung auch noch ein Hochfrequenzsignal der Diode zugeführt. Die gleichzeitige Ankopplung beider Signale an die Koaxialleitung erfordert einen relativ hohen Aufwand. Auch ist nicht auszuschließen, daß sich die für die Kontaktierung des Koaxialinnenleiters mit der Diode erforderliche Feder störend auf das Hochfrequenzsignal, vor allem wenn es von sehr hoher Frequenz (>10 GHz) ist, auswirkt. Die Koaxialleitung hat ebenso den Nachteil, daß sie keine variable Abstimmung der Diodenimpedanz auf das Hochfrequenzsignal besitzt. Eine variable Abstimmung der Koaxialleitung wäre auch, wenn überhaupt, nur sehr schwer zu realisieren.

Der Erfindung liegt nun die Aufgabe zugrunde, eine Vorrichtung der eingangs genannten Art anzugeben, die mit einfachen Mitteln eine störungsfreie und leicht abstimmbare Gleichspannungs- und Hochfrequenzsignalzuführung für eine Diode ermöglicht.

Erfindungsgemäß wird diese Aufgabe dadurch gelöst, daß in den Hohlleiter senkrecht zu den elektrischen Feldlinien eine ein Hochfrequenzsignal zuführende planare Leitung hineinragt und daß die planare Leitung so im Abstand zu der Diode angeordnet ist, daß zwischen beiden eine kapazitive Kopplung besteht.

Zweckmäßige Ausführungen der Erfindung gehen aus den Unteransprüchen hervor.

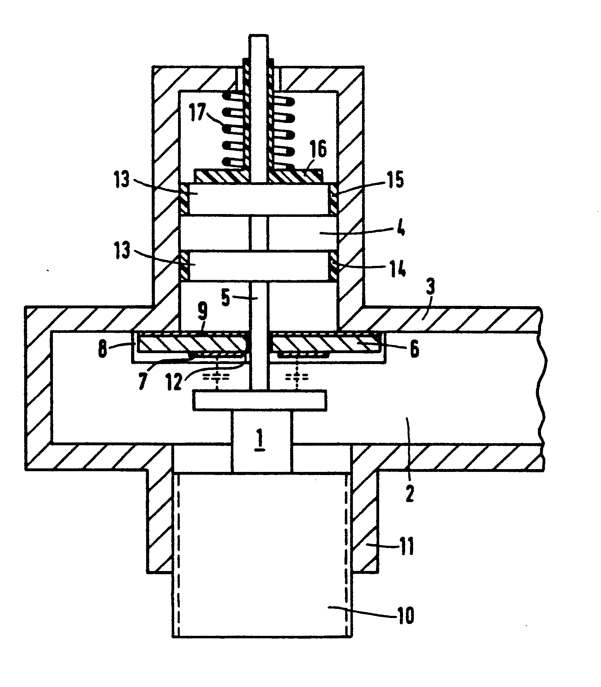

Anhand eines in der Zeichnung dargestellten Ausführungsbeispiels wird anschließend die Erfindung näher erläutert.

Die Figur zeigt einen Längsschnitt durch einen Frequenzvervielfacher, bei dem eine Diode 1 in einem einseitig kurzgeschlossenen Hohlleiter 2 angeordnet ist. Am Hohlleiter 2 ist an seiner der Diode 1 gegenüberliegenden Breitseite 3 eine Koaxialleitung 4 angekoppelt, deren Innenleiter 5 einen galvanischen Kontakt mit der Diode 1 bildet. Diese Koaxialleitung 4 dient allein dazu, der Diode 1 eine Gleichspannung zuzuführen.

Ein Hochfrequenzsignal wird, getrennt von der Gleichspannungszuführung, über eine planare Leitung an die Diode 1 angekoppelt. Eine planare Leitung bietet nämlich ideale Abstimmöglichkeiten für ein Hochfrequenzsignal. Auf Grund der nichtlinearen Eigenschaften der Diode 1 erfährt das Hochfrequenzsignal eine Frequenzvervielfachung. Das so entstandene Hochfrequenzsignal mit höherer Frequenz breitet sich durch den Hohlleiter 2 aus. Der Hohlleiter 2 ist dabei so dimensioniert, daß er nur die Ausbreitung des Signals mit der vervielfachten Frequenz zuläßt.

Die planare Leitung ist in diesem Ausführungsbeispiel ein auf einem Substrat 6 angeordneter Streifenleiter 7. Das Substrat 6 ragt durch eine Öffnung 8 in einer Wand der Hohlleiterschmalseite in den Hohlleiter 2 hinein und zwar quer zu den elektrischen Feldlinien der sich im Hohlleiter ausbreitenden Wellen, um diese möglichst wenig zu stören.

Zwischen dem das Hochfrequenzsignal führenden Streifenleiter 7 und der Diode 1 besteht eine kapazitive Kopplung. Dabei ist das Substrat 6 mit seiner Massefläche 9 an der der Diode 1 gegenüberliegenden Wand 3 der Hohlleiterbreitseite angelötet und der Streifenleiter 7 auf dem Substrat 6 der Diode 1 zugewandt. Die zwischen dem Streifenleiter 7 und der Diode 1 gebildete kapazitive Blindwiderstandskomponente, deren Größe vom Abstand zwischen dem Streifenleiter 7 und der Diode 1 abhängt, wird ausgenutzt, um den induktiven Blindwiderstand der Diode 1 zu kompensieren.

Damit die kapazitive Blindwiderstandskomponente auf einen gewünschten Wert eingestellt werden kann, ist die Eintauchtiefe der Diode 1 in den Hohlleiter 2 und damit der Abstand zwischen Diode 1 und Streifenleiter 7 variierbar. Dazu sitzt die Diode 1 auf einem Gewindebolzen 10, der in einem an den Hohlleiter 2 angesetzten Gewindestutzen 11 verdrehbar gelagert ist.

Das über der Diode 1 angeordnete Substrat 6 weist eine Öffnung 12 auf für den Durchtritt des mit der Diode kontaktierten Innenleiters 5 der Koaxialleitung 4.

Die Koaxialleitung 4 ist mit einer Radialkreissperre 13 zur Abblockung der Hochfrequenzsignale versehen. Isolationsteile 14 und 15, welche die Leitungsabschnittte der Radialkreissperre 13 umgeben, stützen den Innenleiter gegenüber dem Außenleiter dem Koaxialleitung der Koaxialleitung 4 ab. Der Innenleiter 5 ist in axialer Richtung verschiebbar gelagert. Eine durch ein Isolierteil 16 gegenüber dem Innenleiter isolierte Schraubenfeder 17 sorgt dafür, daß der Innenleiter 5 bei jeder beliebigen Stellung der Diode 1 mit dieser einen sicheren Kontakt eingeht.

Der oben beschriebene Frequenzvervielfacher kann in einen Mischer umgewandelt werden, indem über die Koaxialleitung 4 neben der Gleichspannung auch noch ein Zwischenfrequenzsignal der Diode 1 zugeführt wird, dessen Frequenz sehr viel niedriger als die der Hochfrequenzsignale ist.

## Patentansprüche

1. Vorrichtung zum Zuführen einer Gleichspannung und mindestens eines Hochfrequenzsignals an eine in einem Hohlleiter angeordnete Diode, welche mit dem Innenleiter einer die Gleichspannung zuführenden Koaxialleitung kontaktiert ist, dadurch gekennzeichnet, daß in den Hohlleiter (2) senkrecht zu den elektrischen Feldlinien eine ein Hochfrequenzsignal zuführende planare Leitung (6, 7, 9) hineinragt und daß die planare Leitung so im Abstand zu der Diode (1) angeordnet ist, daß zwischen beiden eine kapazitive Kopplung besteht.

2. Vorrichtung nach Anspruch 1, dadurch gekennzeichnet, daß die Eintauchtiefe der Diode (1) in den Hohlleiter (2) variierbar ist, wodurch ein gewünschter Abstand zwischen der Diode (1) und der planaren Leitung (6, 7, 9) eingestellt werden kann.

3. Vorrichtung nach Anspruch 1, dadurch gekennzeichnet, daß die planare Leitung (6, 7, 9) eine Öffnung (12) aufweist zur Durchführung des mit der Diode (1) kontaktierten Innenleiters (5) der Koaxialleitung (4).

4. Vorrichtung nach Anspruch 1, dadurch gekennzeichnet, daß die planare Leitung (6, 7, 9) an einer Hohlleiterwand (3) der Hohlleiterbreitseite befestigt ist.

5. Vorrichtung nach einem der vorhergehenden Ansprüche, dadurch gekennzeichnet, daß die planare Leitung, ein auf einem Substrat (6) angeordneter Streifenleiter (7) ist.

6. Vorrichtung nach Anspruch 5, dadurch gekennzeichnet, daß das Substrat (6) eine Massefläche (9) aufweist, die mit einer Hohlleiterwand (3) der Hohlleiterbreitseite verlötet ist.

## Claims

1. Device for supplying a DC voltage and at least one high frequency signal to a diode disposed in a waveguide, said diode being in contact with a coaxial line supplying the DC voltage, characterized in that, perpendicularly to the electric field lines, a planar line (6, 7, 9) projects into the waveguide (2) and said planar line is arranged at such a distance from the diode (1) that capacitive coupling exists between said diode and said planar line.

2. Device according to claim 1, characterized in that the immersion depth of the diode (1) into the waveguide (2) is variable, thus providing for the setting of a desired distance between the diode (1) and the planar line (6, 7, 9).

3. Device according to claim 1, characterized in that the planar line (6, 7, 9) is provided with an aperture (12) for the passage of the inner conductor (5) of the coaxial line (4), said inner conductor being in contact with said diode (1).

4. Device according to claim 1, characterized in that the planar line (6, 7, 9) is fastened to a wall (3) on the broadside of the waveguide.

5. Device according to one of the preceding claims, characterized in that the planar line is a stripline (7) disposed on a substrate (6).

6. Device according to claim 5, characterized in that the substrate (6) has a ground surface (9) which is soldered to a wall (3) on the broadside of the waveguide.

## Revendications

1. Dispositif pour amener une tension continue et au moins un signal à haute fréquence à une diode disposée dans un guide d'ondes et qui est mise en contact avec le conducteur intérieur d'une ligne coaxiale amenant la tension continue, caractérisé en ce qu'une ligne de structure plane (6, 7, 9), amenant un signal à haute fréquence, fait saillie dans le guide d'ondes (2), perpendiculairement aux lignes de champ électrique, et que la ligne de structure plane est disposée à distance de la diode (1), de manière qu'un couplage capacitif existe entre elles.

2. Dispositif selon la revendication 1, caractérisé en ce que la profondeur de pénétration de la diode (1) dans le guide d'ondes (2) est variable, ce qui permet d'ajuster une distance désirée entre la diode (1) et la ligne de structure plane (6, 7, 9).

3. Dispositif selon la revendication 1, caractérisé en ce que la ligne de structure plane (6, 7, 9) présente une ouverture (12) pour la traversée du conducteur intérieur (5), mis en contact avec la diode (1), de la ligne coaxiale (4).

4. Dispositif selon la revendication 1, caractérisé en ce que la ligne de structure plane (6, 7, 9) est fixée à une paroi (3) du guide d'ondes sur un grand côté de celui-ci.

5. Dispositif selon une des revendications précédentes, caractérisé en ce que la ligne de structure plane est une microbande (7) disposée sur un substrat (6).

6. Dispositif selon la revendication 5, caractérisé en ce que le substrat (6) présente une face (9) de mise à la masse, qui est soudée à une paroi (3) du guide d'ondes sur un grand côté de celui-ci.